# EUROPEAN PATENT APPLICATION

(11) **EP 3 780 289 A1**
(43) Date of publication of application: **17.02.2021**
(21) Application number: 19192082.6
(22) Date of filing: 16.08.2019
(51) Int. Cl.: H01R 13/6594, H05K 9/00, H01R 13/6582

(54) **SHIELDING HOUSING FOR A DETACHABLE FULLY SHIELDED INTERNAL CABLE ASSEMBLY**

(71) Applicant: TE Connectivity Belgium BVBA, 8020 Oostkamp (BE); Tyco Electronics Svenska AB, 194 26 Upplands Väsby (SE); TE Connectivity Corporation, Berwyn, PA 19312 (US)
(72) Inventor: Decrock, Lieven, 8800C Roeselare (BE); Barrefelt, Rickard Valentin, 11825 Stockholm (SE); Rowe, Dustin Grant, Harrisburg, PA Pennsylvania 17109 (US); May, Yublia, Hershey, PA Pennsylvania 17033 (US); Hostrander, Kylie Elizabeth, Hershey, PA Pennsylvania 17033 (US); Long, Richard James, Columbia, PA Pennsylvania 17512 (US); Lachman, Julia Anne, York, PA Pennsylvania 17404 (US); Rita, Jacob, Lancaster, PA Pennsylvania 17603 (US); Valentine, Charles Jameson, Lancaster, PA Pennsylvania 17602 (US); Andersson, Magnus, 17771 Järfälla (SE)
(74) Representative: Grünecker Patent- und Rechtsanwälte PartG mbB

(57) **Abstract**

The object of the present invention is to provide a shielding housing, preferably a shielding housing for an electrical connector assembly, which suppresses cross-talk and lowers the risk of electromagnetic interference (EMI). The object is achieved by providing a shielding housing (1) made from sheet material with electrically conductive and/or magnetically permeable properties. The shielding housing (1) comprises a receptacle (5), which is configured to receive the electrical connector assembly (27). For this, the receptacle (5) is formed as a straight passage (7) with openings (9) at both ends (11). Either end (11) is configured for receiving one electrical connector (25) of the electrical connector assembly (27). Either end (11) is further configured for creating an electrical contact between the shielding housing (1) and a backshell (45) of each of the received electrical connector (25). Thus, the shielding housing (1) seamlessly shields the electrical connector assembly (27) from electromagnetic radiation when the electrical connectors (25) are received in the shielding housing (1). This suppresses cross-talk between the electrical connector assembly (27) and the surrounding, as well as it lowers the risk of EMI to and from the electrical connector assembly (27).

## Description

### Technical Field to which the Invention Relates

The present invention relates to an internal cable assembly and, more particularly, to a shielding housing for a detachable fully shielded internal cable assembly.

### Background Art

Data transmission between separate systems (e.g. two separate electrical devices and/or two separate circuit boards of the same electrical device) is necessary in many applications of the telecommunication industry. In the prior art, such data transmission is realized by providing a receptacle (e.g. SFP board connector) for an external plug (e.g. SFP plug) on the edge of a circuit board to where an external cable can be connected. The data is transmitted to and from an external transceiver through the external cable and via conductive tracks, which are positioned on the circuit board and connect the receptacle with the according elements on the circuit board for which the data transmission is intended. However, the data transmission via the conductive tracks of the circuit board is prone to transmission losses and limited in its transmission rate.

In applications where high-speed data transmission is required, a bypass connection can be used. Through a suitable internal cable assembly, the bypass connection directly connects the receptacle to the corresponding elements on the circuit board for which the high-speed data transmission is intended. The internal cable assembly comprises a separate over-the-board cable which runs over the circuit board, and is therefore independent from the conductive tracks of the circuit board. Thus, the transmitted data is not routed via the conductive tracks of the circuit board, which impose a limitation on the transmission rate. Yet such an internal cable assembly of the bypass connection is prone to cross-talk.

### Technical Problem to be Solved

The object of the present invention is to improve said internal cable assembly in terms of cross-talk suppression and to generally lower the risk of electromagnetic interference (EMI) involving the internal cable assembly.

### Disclosure of Invention

The problem is solved by providing a shielding housing, which is configured to receive an electrical connector assembly, such as an internal cable assembly of a high-speed bypass connection. The shielding housing comprises a receptacle, wherein the receptacle is formed as a straight passage with openings at both ends. Either of the ends is configured for receiving an electrical connector of the electrical connector assembly and/or a mating connector for the electrical connector. The reception takes place along a mating axis, which runs coaxially with the straight passage of the receptacle. Furthermore, the reception allows the electrical connector and the mating connector to be mated within the receptacle.

Apart from the reception of the electrical connector and the mating connector, the shielding housing is configured to be in electrical contact with an outer housing of the electrical connector and/or the mating connector.

According to this solution, a seamless EMI-shielding for the entire combined length of the electrical connector and the mating connector is provided. Thus, cross-talk suppression is improved and the risk of EMI involving the electrical connector assembly is lowered.

The above solution may be further improved by adding one or more of the following optional features. Hereby, each of the following optional features is advantageous on its own, and may be combined independently with any other optional feature.

In one embodiment of the present invention, at least one end of the receptacle may comprise at least one locking mechanism for locking at least one of the connectors (i.e. the electrical connector and/or the mating connector). More particularly, the locking mechanism may be configured to securely hold at least one of the connectors (i.e. the electrical connector and/or the mating connector). The locking mechanism may be arranged adjacently to one of the openings of the receptacle and may form a continuation of the straight passage. Providing a locking mechanism prevents an undesired disconnection of the electrical connector and mating connector, while also ensuring that the electrical connector and/or mating connector are received in the correct orientation.

Additionally or alternatively, at least one end of the receptacle may be configured for receiving at least one optic module of a fiber optic cable, the optic module functioning as a converter of a signal of an optic cable into a signal of an electrical cable and vice versa. This configuration broadens the applicability of the present invention by allowing the shielding housing to be used with electrical connectors and/or optical modules.

In another embodiment, the shielding housing may be formed from a single folded sheet that has an electrically conductive property. More particularly, the electrically conductive property may be derived from the usage of an electrically conductive sheet material, the usage of a sheet material containing doped particles and/or the usage of a sheet material, which is coated with an electrically conductive coating.

In this embodiment, the sheet may be folded around the receptacle in order to form the shielding housing with the openings at both ends. Thus, the reception of the electrical connector and/or the mating connector may take place by inserting the electrical connector and/or the mating connector into to the receptacle through either one or both of the openings along a direction parallel to the mating axis.

Forming the shielding housing from a single folded sheet reduces the number of components constituting the shielding housing. Thus, manufacturing of the shielding housing is facilitated. The usage of an electrically conductive material enables the sheet to better reflect electromagnetic radiation, giving the sheet the capability of EMI-shielding as it prevents the penetration of electromagnetic radiation through the sheet.

Additionally or alternatively, the single folded sheet may also possess a magnetically permeable property and/or a shielding efficiency amounting to a predefined value. The magnetic permeability enables the sheet to better absorb electromagnetic radiation. Thus, the sheet may act as an EMI-shield by preventing the penetration of the electromagnetic radiation through the sheet. Preferably, a shielding efficiency amounting to a predefined value according to the application of the shielding housing should be implemented in order to achieve excellent EMI-shielding.

In a preferable embodiment, the sheet may be folded around the receptacle of the shielding housing, wherein opposite ends with respect to a circumferential direction (the circumferential direction extending around the receptacle) may be latched together. This way, the sheet may fulfill the function of the receptacle while providing the necessary EMI-shielding through reflection and/or absorption of electromagnetic radiation. The usage of a latching mechanism prevents unwanted unfolding of the sheet.

Additionally or alternatively, the opposite ends may be engaged with one another through a form fit and/or a positive-locking fit.

In yet another embodiment, the shielding housing may comprise at least one side or surface with a plurality of cooling holes. This embodiment is especially preferable, when at least one optic module of a fiber optic cable is received by the receptacle. Through the cooling holes, thermal energy is better transported from the interior of the shielding housing to the surrounding, thus preventing overheating.

One possible embodiment of the shielding housing may comprise a plurality of attachment means, the attachment means being configured for insertion into and/or attachment onto a circuit board, preferably a printed circuit board (PCB). The attachment means fixate the shielding housing on the PCB and absorb mechanical stress, which is imposed on the shielding housing e.g. by external forces pulling on the electrical connector. Thus, the attachment means also protect the shielding housing from mechanical strain.

Alternatively, the shielding housing may comprise as a separate component an adapter with a plurality of attachment means, preferably a plurality of pins. The adapter, preferably a metallic support, may be configured for attachment to a circuit board, preferably a PCB, via the attachment means. More particularly, the attachment means may be configured for an insertion into and/or an attachment onto the circuit board. The adapter may further be configured to engage with the shielding housing into a form-fit connection and preferably be secured through a latching mechanism. In this way, the adapter may serve as a support for the shielding housing on the circuit board.

By positioning the attachment means on a separate component (i.e. the adapter), the shielding housing may be designed in a more compact, closed manner with fewer holes. Thus, the EMI-shielding performance of the shielding housing may be further improved.

The shielding housing may also be attached to any other type of adapter or suitable support structure, e.g. on a bulkhead or in a chamber.

In another embodiment, the shielding housing may be formed from at least two separate parts, preferably at least two separate sheets. More particularly, one of the at least two sheets is folded to form a section of the receptacle, while the other of the at least two sheets is folded to form a complimentary section of the receptacle. This embodiment is especially favourable when the shielding housing is to be assembled as part of an electrical connector assembly through a pick and place assembly process. It is to be noted that a single sheet shielding housing is also compatible with a pick and place assembly process.

Further, each of the at least two separate parts, preferably at least two separate sheets, may be formed by a material with an electrically conductive property, a magnetically permeable property and/or a shielding efficiency amounting to a predefined value according to the application of the shielding housing. The technical advantage of these properties is discussed above.

In yet another embodiment, the shielding housing may comprise at least one spring finger at at least one of the openings, wherein the spring finger is elastic and bent in a direction perpendicular to the mating axis. The elasticity allows the spring finger to compensate inaccuracies deriving from manufacturing tolerances. More particularly, the spring finger may create a bias against any of the received electrical connectors and/or mating connectors, thus positioning and/or fixating said connector. The spring finger may also engage in electrical contact with a backshell of the received electrical connector and/or mating connector, thus providing a seamless EMI-shielding. The spring finger may further have the function of removing dust, dirt and/or other contamination from the received electrical connector and/or mating connector, when said connector is received by the receptacle.

Additionally, the at least one spring finger may be bent outwards away from one of the openings and towards the respective opposite opening. Alternatively, the at least one spring finger may be bent backwards into one of the openings and towards the respective opposite opening. The outwards bent spring finger may be configured to create electrical contact with a front panel positioned on the edge of the PCB. The inwards bent spring finger may be configured to create electrical contact with the backshell of the received connector.

In yet another embodiment, the at least one spring finger may protrude away from the receptacle along the direction of the mating axis.

In another embodiment, the shielding housing may comprise a plurality of such spring fingers arranged around the periphery of at least one of the openings. More particularly, more than one spring finger may be arranged at one side of at least one of the openings. A higher quantity of spring fingers may provide a larger total cross-section to conduct electrical currents through the electrical contact between the spring fingers and the backshell of the received connector. Having more than one spring finger arranged at one side of the openings may reduce the size of the slits between the shielding housing and the backshell of the received connector, the slits being a cause for leakage of electromagnetic radiation.

In any of the above-mentioned embodiments, the attachment means may be arranged on one part, preferably on one sheet. More particularly, the attachment means and the at least one spring finger may be stamped out of the shield material. Furthermore, the at least one spring finger may be folded and/or bent backwards into one of the openings and towards respective opposite openings. Stamping the attachment means and the at least one spring finger as an integral part of the sheet facilitates and shortens the manufacturing process, as these elements do not have to be added in a separate step.

Alternatively, the at least one spring finger may be formed by a separate part, which is attached, preferably by a welding process, to the shielding housing. In case the shielding housing comprises a plurality of spring fingers, at least one spring finger may be stamped out of the shield material while at least one other spring finger may be formed by a separate part. This allows having spring fingers bent inwards and outwards at the same circumferential position of at least one of the openings.

Additionally or alternatively, a gasket may be attached at at least one of the openings, wherein the gasket at least partly surrounds the periphery of that opening and is made of a material that has an electrically conductive property, a magnetically permeable property and/or a shielding efficiency amounting to a predefined value according to the application of the shielding housing. The gasket may further be configured to seamlessly shut any slits or gaps between the shielding housing and the backshell of the received connector, thus preventing the leakage of electromagnetic radiation.

In another embodiment, one of the openings has a cross-sectional area perpendicular to the mating axis that is smaller than the cross-sectional area perpendicular to the mating axis of the other opening, wherein the difference in the cross-sectional areas is covered by the shielding housing. More particularly, the shielding housing comprises at one of the openings a shoulder, the shoulder being formed by a section of the sheet material, which is folded in such a way that it faces in the direction of the mating axis and partly covers the one opening with the smaller cross-sectional area. Furthermore, a projection may protrude from the opening with the smaller cross-sectional area to form a continuation of the straight passage. This embodiment is especially preferred, when connectors with different cross-sectional areas perpendicular to the mating axis are to be mated within the shielding housing, as the openings of the shielding housing can be adjusted individually in terms of height and/or width.

In one embodiment, the projection may be configured to receive at least one of the connectors (i.e. the electrical connector and/or the mating connector). The projection may further comprise a locking mechanism for locking at least one of the connectors (i.e. the electrical connector and/or the mating connector). More particularly, the locking mechanism may be configured to securely hold at least one of the connectors (i.e. electrical connector and/or mating connector).

In any one of the above-mentioned embodiments, the shielding housing may be attached to a circuit board, preferably a printed circuit board, through the attachment means. Attaching the shielding housing to the circuit board prevents loss and unwanted movement of the shielding housing.

In yet another embodiment, the shielding housing may be part of a cable assembly (e.g. an internal cable assembly), wherein the cable assembly may comprise at least an electrical connector and/or a mating connector. The at least one electrical connector and/or mating connector may be at least partly received in the shielding housing, which seamlessly shields at least parts of the electrical connector and/or the mating connector from EMI, when the electrical connector and/or the mating connector is received in the shielding housing. Additionally, the corresponding other connector may be received individually in the shielding housing and mated with the already received electrical connector or mating connector, respectively. In this case, the shielding housing provides seamless EMI-shielding for the entire combined length of the received electrical connector, the shielding housing and the received mating connector. The seamless EMI-shielding suppresses cross-talk between the received electrical connector assembly and other components in the vicinity. This way, antennas are especially protected from receiving disruptive electromagnetic radiation from the received electrical connector assembly. Additionally, the EMI-shielding protects unmated connectors that are received in the shielding housing from external disruptive electromagnetic radiation. This is especially convenient if multiple electrical connector assemblies are positioned in direct vicinity to each other and some assemblies are left unmated, while other assemblies are in a mated state. In such a constellation, the EMI-shielding prevents the unmated connectors from picking up undesired external electromagnetic radiation.

In one embodiment, the cable assembly may comprise a plurality of shielding housings, each of the shielding housings being configured to receive a separate electrical connector assembly, comprising at least an electrical connector and/or a mating connector, respectively. In this constellation, multiple elements on the PCB may be connected with external transceivers simultaneously.

In another embodiment, the cable assembly may further comprise a shielded cable extending from at least one of the connectors (i.e. the electrical connector and/or the mating connector), preferably one shielded cable extends from each electrical connector and mating connector. In this case, the cable assembly may be seamlessly shielded from EMI along its entire combined length.

In any of the above-mentioned embodiments of the cable assembly, the electrical connector and/or mating connector are detachable from the shielding housing. Preferably, both the electrical connector and the mating connector are detachable from the shielding housing. More particularly, the electrical connector and /or the mating connector may comprise a backshell, which is a die cast backshell, a plated plastic backshell or a formed metal backshell. The backshell is configured to be securely held by the locking mechanism of the receptacle. Furthermore, the backshell is configured to engage in electric contact with the at least one spring finger and/or the gasket. Additionally or alternatively, the backshell may comprise at least one spring finger for this purpose. The usage of detachable connectors brings the advantage that the connectors may be mated and unmated according to the application and/or operational circumstances.

In the following, exemplary embodiments of the invention are described with reference to the drawings. The shown and described embodiments serve explanatory purposes only. The combination of features shown in the embodiments may be changed according to the foregoing description. For example, a feature which is not shown in an embodiment but described above may be added if the technical effect associated with this feature is beneficial for a particular application. Vice versa, a feature shown as part of an embodiment may be omitted as described above if the technical effect associated with this feature is not needed in a particular application.

In the drawings, elements that correspond to each other with respect to function and/or structure have been provided with the same reference numeral.

In the drawings,
- Fig. 1: shows a schematic rendition of a perspective view of a shielding housing according to one possible embodiment of the present disclosure;
- Fig. 2: shows a schematic rendition of an exploded view of a shielding housing and a mating connector according to another possible embodiment of the present disclosure;
- Fig. 3: shows a schematic rendition of a perspective view of the shielding housing and the mating connector according to the embodiment shown in Fig. 2;
- Fig. 4: shows a schematic rendition of a perspective view of a shielding housing according to another possible embodiment of the present disclosure;
- Fig. 5: shows a schematic rendition of a perspective view of a shielding housing, a mating connector and an electrical connector according to yet another possible embodiment of the present disclosure;
- Fig. 6: shows a schematic rendition of a perspective view of a shielding housing according to another possible embodiment of the present disclosure;
- Fig. 7: shows a schematic rendition of another perspective view of the shielding housing according to the embodiment shown in Fig. 6;
- Fig. 8: shows a schematic rendition of a perspective view of the shielding housing, the mating connector and the electrical connector according to the embodiment shown in Fig. 6;
- Fig. 9: shows a schematic rendition of a perspective view of a mating connector and an electrical connector without a shielding housing;
- Fig. 10.: shows a schematic rendition of a perspective view of a cable assembly with a plurality of shielding housings, mating connectors and electrical connectors according to the embodiment shown in Fig. 8;
- Fig. 11.: shows a schematic rendition of a perspective view of a shielding housing, a mating connector and an electrical connector according to yet another possible embodiment of the present disclosure; and
- Fig. 12.: shows a schematic rendition of a perspective view of a shielding housing, a mating connector and an electrical connector according to yet another possible embodiment of the present disclosure.

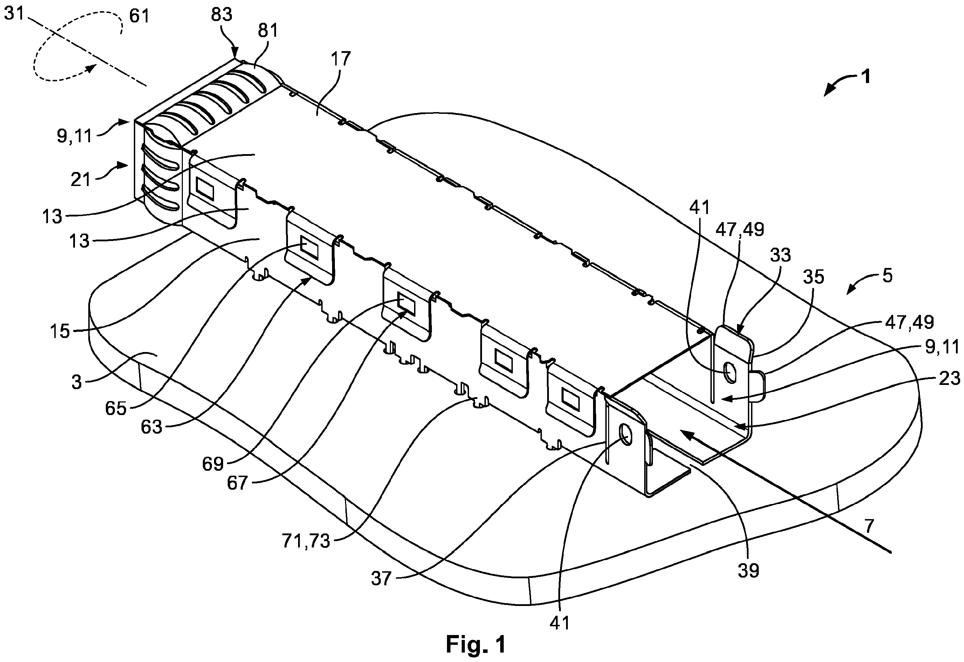

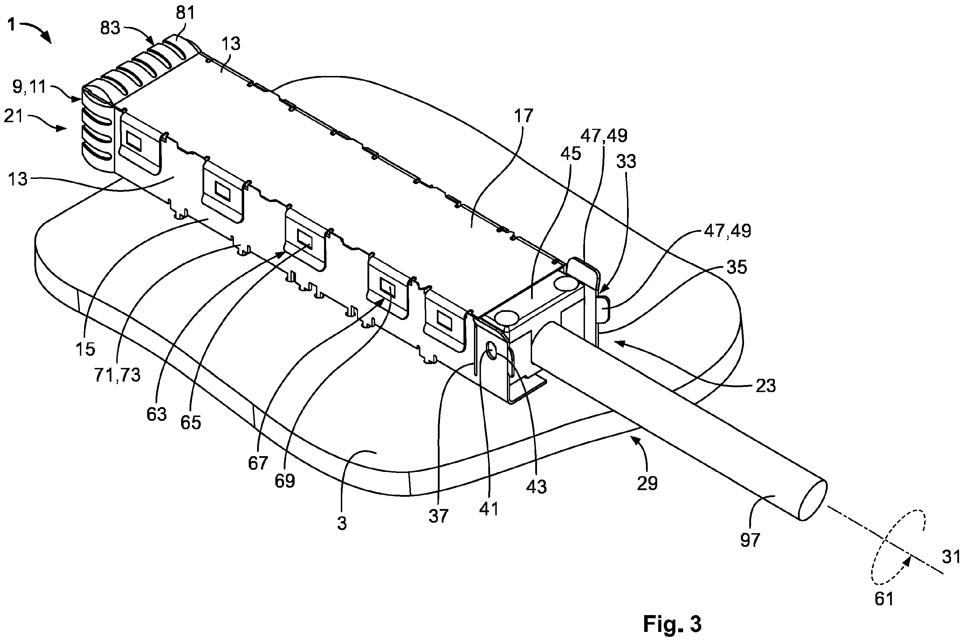

First, the structure of the shielding housing 1 is explained with reference to the exemplary embodiments shown in Figs. 1 to 12.

Fig. 1 shows a perspective view of the shielding housing 1 according to the present disclosure, the shielding housing 1 being attached to a printed circuit board (PCB) 3 in such a way that it extends at least partially over the outer edge of the PCB 3. The shielding housing 1 comprises a receptacle 5, wherein the receptacle 5 is formed as a straight passage 7 with openings 9 at both ends 11. More particularly, the receptacle 5 may comprise at least four substantially rectangular shaped walls 13. Two of the at least four walls 13 may be spaced apart and aligned parallel to each other in a direction perpendicular to the PCB 3 to form two sidewalls 15 of the shielding housing 1. The other two of the at least four walls 13 may be spaced apart and aligned parallel to each other in a direction perpendicular to the two sidewalls 15 to form the top wall 17 and the bottom wall 19 of the shielding housing 1, respectively. All of the at least four walls 13 enclose the straight passage 7, wherein on each end 11 of the enclosed straight passage 7, one of the two openings 9 is positioned forming a front end 21 and a back end 23 of the shielding housing 1. The front end 21 is configured for receiving an electrical connector 25 of an electrical connector assembly 27. The back end 23 is configured for receiving a mating connector 29 for the electrical connector 25.

A mating axis 31 runs coaxially with the straight passage 7 and represents the direction along which the electrical connector 25 and the mating connector 29 are received by the front end 21 and the back end 23, respectively. The lengths of the straight passage 7 along the mating axis 31 is configured in such a way that the electrical connector 25 and the mating connector 29 are matable within the receptacle 5, if the electrical connector 25 and the mating connector 29 are received by the front end 21 and the back end 23, respectively.

As shown in Figs 1 to 10, the receptacle 5 may comprise a locking mechanism 33, which is arranged adjacently to and/or as a part of the front end 21 and/or the back end 23. In the shown embodiment of Figs. 1 to 3, one locking mechanism 33 is formed by a substantially U-shaped projection 35, which protrudes away from the back end 23 along the mating axis 31. The locking mechanism 33 may be separated from the sidewalls 15 through slits 37, which extend along a direction perpendicular to the mating axis 31. Another slit 39, which extends along a direction parallel to the mating axis 31, may separate the locking mechanism 33 into two halves. Each of the two halves may comprise at least one hole of at least one pair of holes 41. Each hole of the at least one pair of holes 41 may be configured to receive a corresponding knob 43, which is positioned on the outside of a backshell 45 of the mating connector 29.

Furthermore, the locking mechanism 33 may comprise a plurality of chamfered edges 47. More particularly, the plurality of chamfered edges 47 may be formed by flaps 49, which obliquely protrude away from the U-shaped projection 35. The chamfered edges 47 are preferably configured in such a way that they facilitate the reception of the knobs 43 in their corresponding holes of the at least one pair of holes 41. More particularly, the chamfered edges 47 are configured to facilitate the reception of the knobs 43 in a direction perpendicular to the mating axis 31 and/or in a direction parallel to the mating axis 31.

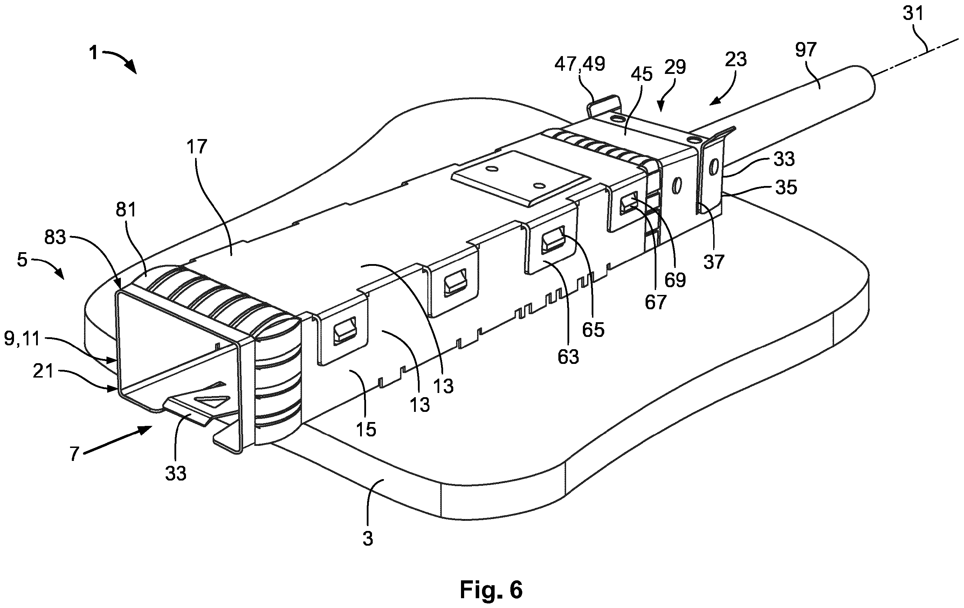

In another exemplary embodiment, the U-shaped projection 35 of the locking mechanism 33 may comprise a plurality of grooves 51, as shown in Figs. 6 to 8. The grooves 51 may be formed by recesses, which extend from an outer edge of the U-shaped projection 35 along a direction parallel or perpendicular to the mating axis 31. Each groove 51 that extends in a direction parallel to the mating axis 31 may be configured to receive a corresponding knob 43, which is positioned on the outside of the backshell 45 of the mating connector 29. Each groove 51 that extends in a direction perpendicular to the mating axis 31 may be configured to receive a corresponding knob 43, which is positioned on a pull tab 53, the pull tab 53 being connected to the backshell 45 of the mating connector 29 through a pivotable hinge 55.

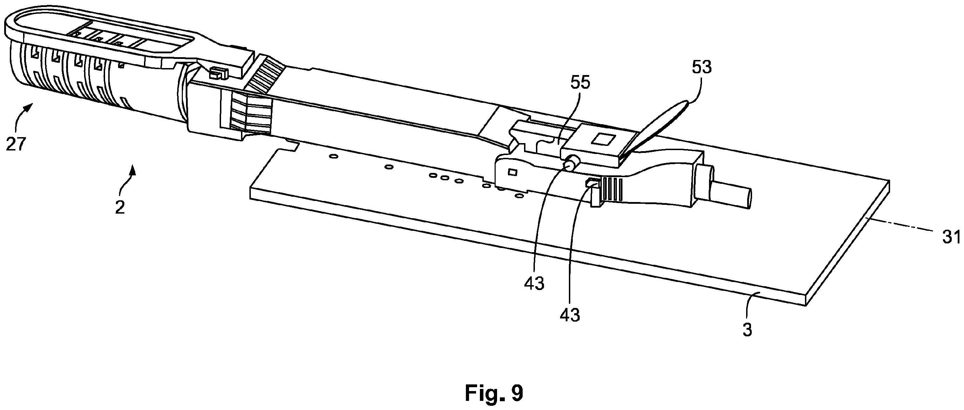

As shown in Fig. 9, the received electrical connector 25 may be a connector of a direct attach cable (DAC), such as an SFP connector, an SFP+ connector or any other type of small form-factor pluggable connector. In this case, the locking mechanism 33 may be a locking mechanism suitable for holding a small form factor pluggable connector as shown in Fig. 6.

The electrical connector 25 may also be an optical module of a fiber-optic cable, the optical module functioning as a converter for a signal of the fiber-optic cable into a signal of an electrical cable and vice versa. In this case, at least one of the sidewalls 15, the top wall 17 or the bottom wall 19 may comprise a plurality of cooling holes 57. The cooling holes 57 are preferably designed with regards to position, diameter and/or distribution in such a way to prevent penetration of electromagnetic radiation of any anticipated frequencies obstructive to the application.

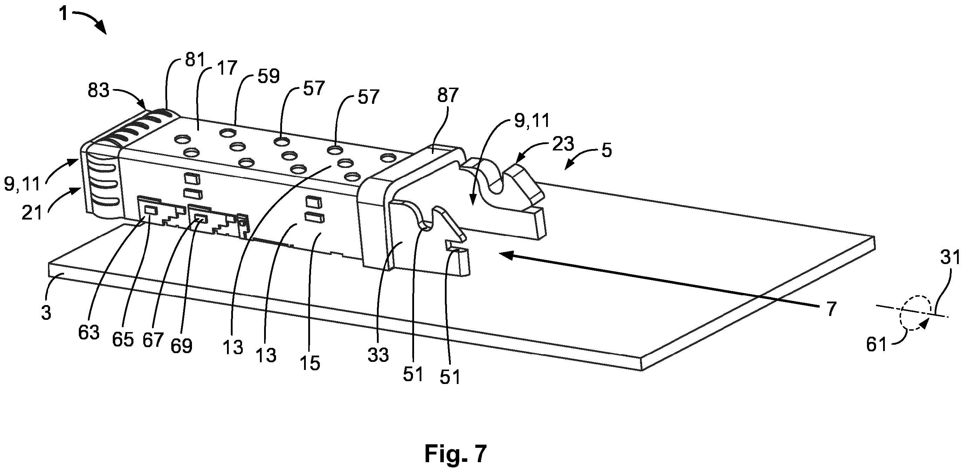

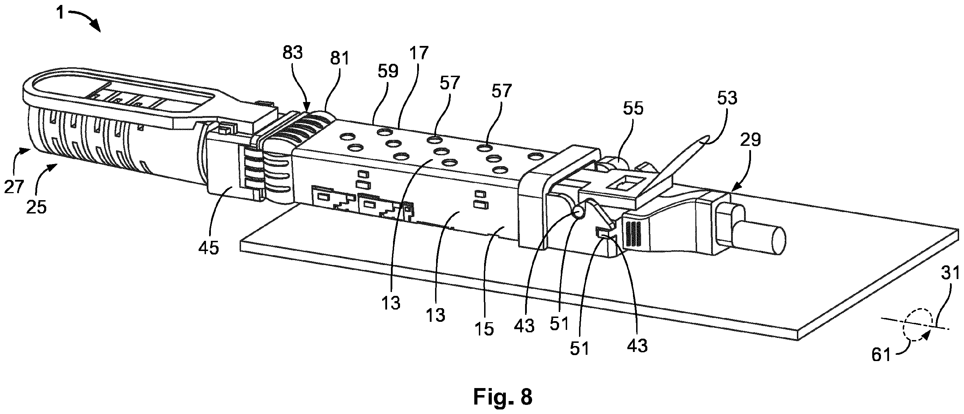

In the exemplary embodiment of the shielding housing 1 shown in Figs. 7 and 8, the shielding housing 1 may be formed from a single folded sheet 59, which is folded around the receptacle 5, wherein opposite ends with respect to a circumferential direction 61 may be latched together. Preferably, the sheet 59 may comprise at least one latch 63 with a latching groove 65 and a chamfered edge 47. Further, the single folded sheet 59 may comprise at least one surface 67 with a latching cam 69. More particularly, the latching groove 65 and the latching cam 69 are configured to engage in a latching connection, when the single folded sheet 59 is folded around the receptacle 5 of the shielding housing 1. The chamfered edge 47 is configured to facilitate the engagement of the latching connection.

In one preferred exemplary embodiment, the sheet 59, the at least one latch 63 with a latching groove 65 and the at least one surface 67 with a latching cam 69 may be integrally stamped out of an electrically conductive material. Additionally or alternatively, the sheet 59, the at least one latch 63 with a latching groove 65 and the at least one surface 67 with a latching cam 69 may be formed by a magnetically permeable material and/or a material with a shielding efficiency amounting to a predefined value according to the application of the shielding housing 1. The sheet 59 and the at least one latch 63 with a latching groove 65 are folded and/or bent around the receptacle 5 of the shielding housing 1 in such a way that the at least one latch 63 with a latching groove 65 is brought into the latching connection with the latching cam 69.

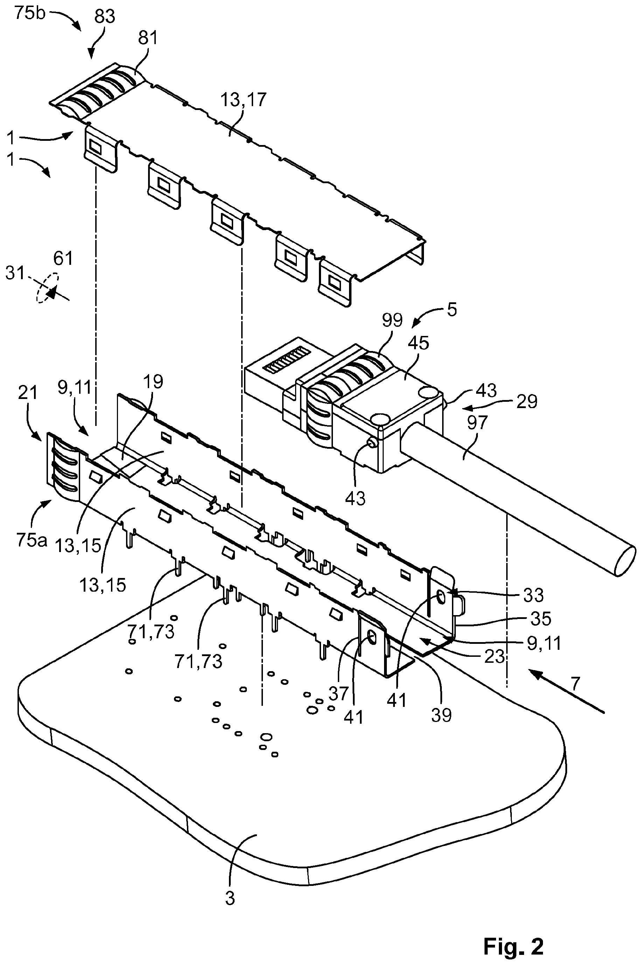

As further shown in Fig. 2, the shielding housing 1 may comprise a plurality of attachment means 71. More particularly, the shielding housing 1 may comprise a plurality of pins 73, which are configured to be inserted into a PCB 3. Preferably, the pins 73 are stamped out of the electrically conductive material as an integral part of the sheet 59. The pins 73 may be bent after the insertion into the PCB 3.

In another exemplary embodiment as shown in Fig. 2, the shielding housing 1 may be formed from at least two separate parts 75a, 75b. Each separate part 75a, 75b may be formed by an electrically conductive sheet material. Additionally or alternatively, each separate part may be formed by a magnetically permeable sheet material and/or a sheet material with a shielding efficiency amounting to a predefined value according to the application of the shielding housing 1.

More particularly, one of the at least two parts 75a, 75b is folded to form a section of the receptacle 5, while the other of the at least two parts 75a, 75b is folded to form a complementary section of the receptacle 5. Preferably, one of the at least two parts 75a, 75b comprises at least one locking mechanism 33. Furthermore, one of the at least two parts 75a, 75b comprises at least one latch 63 with a latching groove 65 and a chamfered edge 47, while the other of the at least two parts 75a, 75b comprises at least one surface 67 with a latching cam 69. More particularly, the latching groove 65 and the latching cam 69 are configured to engage in a latching connection, when the at least two parts 75a, 75b are put together to form the receptacle 5. The chamfered edge 47 is configured to facilitate the engagement of the latching connection.

As shown in Fig. 2, the attachment means 71 are arranged on one of the at least two parts 75a, 75b, preferably on one of the at least two parts 75a, 75b, which comprises the locking mechanism 33. This allows the part 75a with attachment means 71 to be attached primarily to the PCB 3, e.g through a first step of a pick and place assembly process. The part 75b without attachment means 71 may be put onto the part 75a with attachment means 71 thereafter, e.g through a consecutive step of the pick and place assembly process. More particularly, the at least two parts 75a, 75b may engage in the latching connection thereafter.

Optionally, the mating connector 29 may be placed there in between. More particularly, the mating connector 29 may be placed into the part 75a with attachment means 71, e.g. through an intermediate step of the pick and place assembly process, and held by the locking mechanism 33. Thereafter, the part 75b without attachment means 71 may be put onto the part 75a with attachment means 71 already holding the mating connector 29.

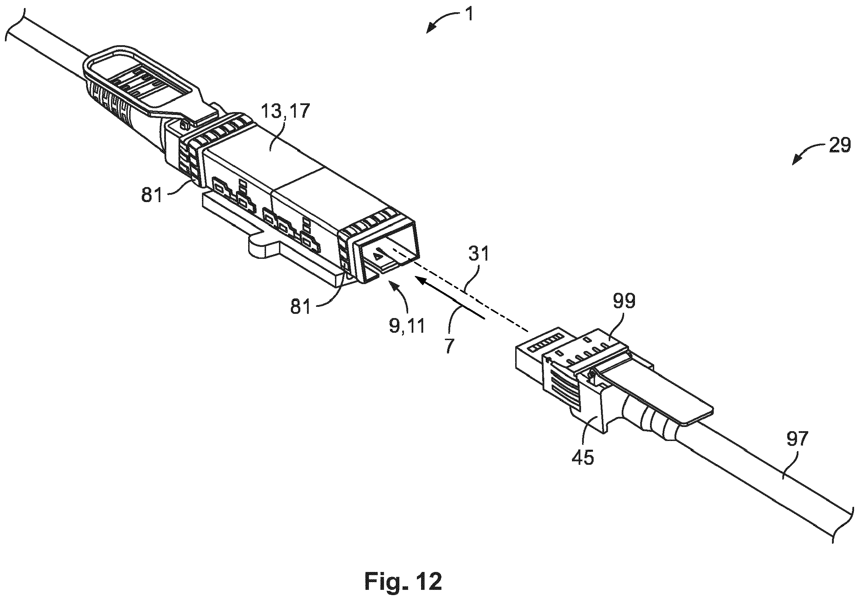

Alternatively, the mating connector 29 may be inserted into the receptacle 5 of the shielding housing 1 after the at least two parts 75a, 75b have already been engaged in the latching connection. In this case, the mating connector 29 is inserted into the receptacle 5 through the opening 9, preferably along a direction parallel to the mating axis 31. Fig. 12 illustrates such an insertion of the mating connector 29 into the receptacle 5 along a direction parallel to the mating axis 31.

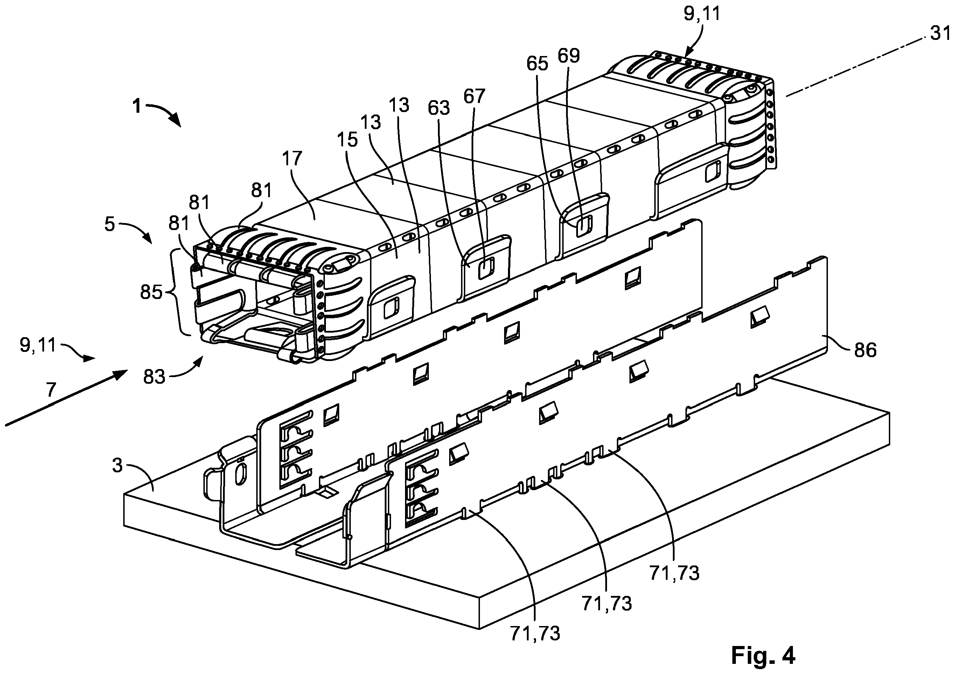

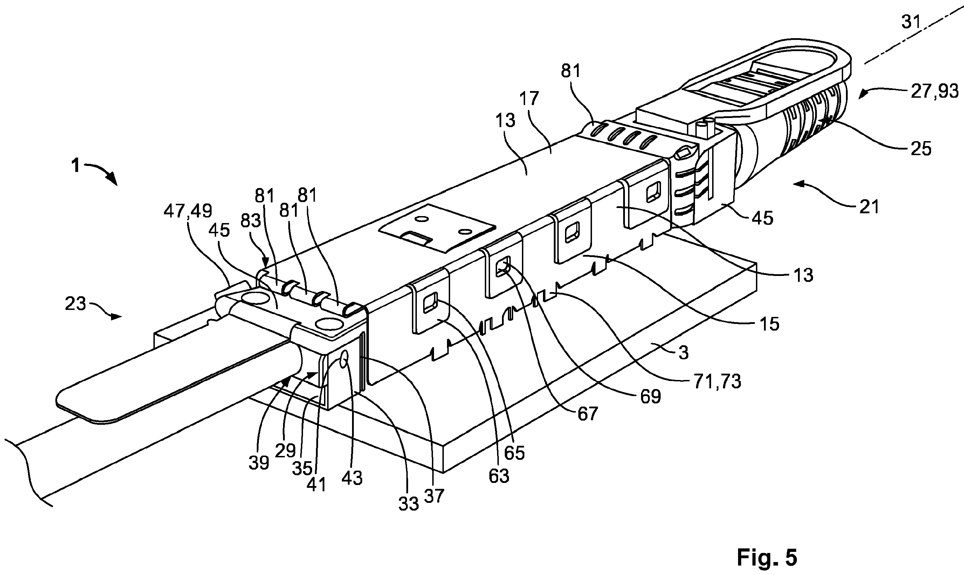

In another exemplary embodiment, the shielding housing 1 may comprise at least one spring finger 81 at at least one of the openings 9 as shown in Figs. 4 and 5. The at least one spring finger 81 is preferably elastic and bent in a direction perpendicular to the mating axis 31. Moreover, the at least one spring finger 81 is further bent backwards into one of the openings 9 and towards the respective opposite opening. The at least one spring finger 81 is configured to create a mechanical bias against the mating connector 29, which is received in the receptacle 5. This allows the positioning and fixation of the mating connector 29.

Furthermore, the at least one spring finger 81 is configured to engage in electrical contact with the mating connector 29. More particularly, the at least one spring finger 81 is configured to provide an electrical link between the shielding housing 1 and the backshell 45 of the mating connector 29, thus providing a seamless EMI-shielding.

Preferably, a plurality of spring fingers 81 is arranged around the periphery 83 of at least one of the openings 9. More particularly, more than one spring finger 81 is arranged at one side 85 of the receptacle 5.

In one preferable exemplary embodiment, the shielding housing 1, the attachment means 71, e.g. the pins 73, and the at least one spring finger 81 is stamped out of the same sheet material, wherein after the stamping the at least one spring finger 81 is folded and/or bent backwards into one of the openings 9 and towards the respective opposite opening. Additionally or alternatively, at least one other spring finger 81 may be formed by a separate sheet material and may be welded onto the shielding housing 1, as shown in Fig. 4.

As can also be seen in Fig. 4, the shielding housing 1 may comprise an adapter 86, preferably a metallic support, as a separate component. The adapter 86 may comprise the attachment means 71, preferably the pins 73. The adapter 86 may further be configured for attachment to the PCB 3 via the attachment means 71. In addition, the adapter 86 may be configured to engage into a form-fit connection with the shielding housing 1. In particular, the shielding housing 1 may be secured by the adapter 86 through a latching mechanism (not shown).

As an addition or alternative to the spring fingers 81, a gasket 87 may be attached at at least one of the openings 9, wherein the gasket 87 at least partly surrounds the periphery 83 of that opening 9 and is made of a material that has an electrically conductive property, a magnetically permeable property and/or a shielding efficiency amounting to a predefined value according to the application of the shielding housing 1.

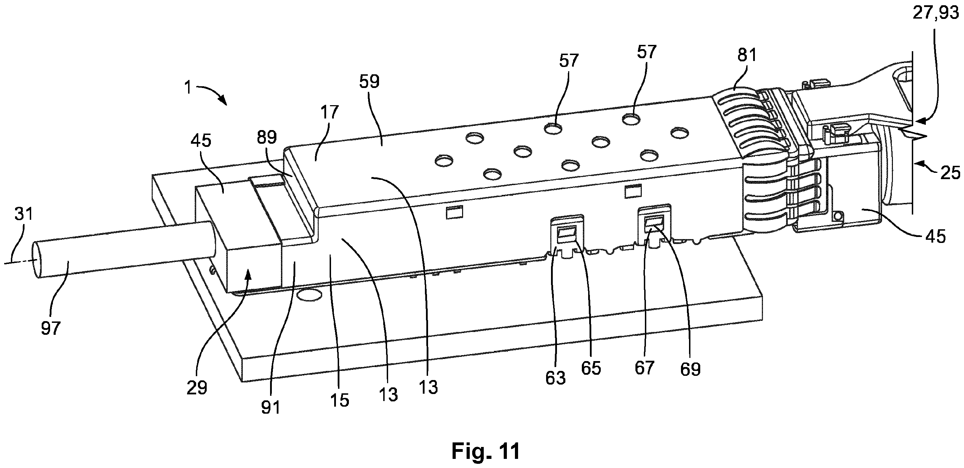

Fig. 11 shows yet another possible embodiment of the shielding housing 1, wherein one opening 9 has a cross-sectional area perpendicular to the mating axis 31 that is smaller than the cross-sectional area perpendicular to the mating axis 31 of the other opening 9. The difference in the cross-sectional area is preferably covered by the shielding housing 1. More particularly, the shielding housing 1 comprises at one opening 9 a shoulder 89. The shoulder 89 is formed by a section of the folded sheet 59, which is folded in such a way that it faces in the direction of the mating axis 31 and partly covers the opening 9 with the smaller cross-sectional area.

From the opening 9 with the smaller cross-sectional area, a protrusion 91 may form a continuation of the straight passage 7. The protrusion 91 may also be configured to receive one of the connectors (i.e. the electrical connector 25 or the mating connector 29).

As shown in Figs. 5, the shielding housing 1 may be part of a cable assembly 93, wherein the cable assembly 93 may further comprise at least the electrical connector 25 and/or the mating connector 29. The electrical connector 25 and/or the mating connector 29 may be at least partly received in the shielding housing 1. More particularly, the shielding housing 1 may seamlessly shield at least the received parts of the electrical connector 25 and/or the mating connector 29 from EMI, when the electrical connector 25 and/or the mating connector 29 is received in the shielding housing 1.

Additionally, the corresponding other connector may be received individually in the shielding housing 1 and mated with the already received electrical connector 25 or mating connector 29, respectively. In this case, the shielding housing 1 may provide seamless EMI-shielding for the entire combined length of the received electrical connector 25, the shielding housing 1 and the received mating connector 29.

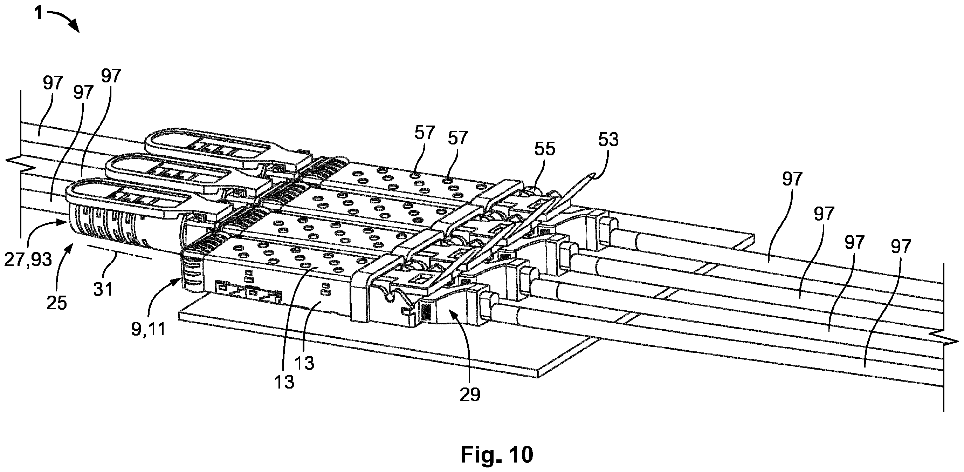

In one exemplary embodiment of the cable assembly 93 shown in Fig. 10, the cable assembly 93 may comprise a plurality of shielding housings 1, wherein each shielding housing 1 is configured to receive a separate electrical connector assembly 27, comprising at least an electrical connector 25 and/or a mating connector 29, respectively.

In any of the above-mentioned embodiments, the cable assembly 93 may further comprise a shielded cable 97 extending from at least one of the connectors (i.e. the electrical connector 25 and/or the mating connector 29), preferably one shielded cable 97 extends from each electrical connector 25 and mating connector 29, as shown in Fig. 10. In this case, the cable assembly 93 may be seamlessly shielded from EMI along its entire combined length.

In any of the above-mentioned embodiments of the cable assembly 93, at least one electrical connector 25 and/or mating connector 29 is detachable from the shielding housing 1. Preferably, all the electrical connectors 25 and all the mating connectors 29 are detachable from the shielding housing 1.

More particularly, at least one electrical connector 25 and/or mating connector 29 may comprise at least one backshell 45. Each backshell 45 is configured to be securely held by a corresponding locking mechanism 33. Furthermore, each backshell 45 is configured to engage in electric contact with the at least one spring finger 81 and/or the gasket 87. As shown in Fig. 2, the backshell 45 may additionally or alternatively comprise at least one spring finger 99, preferably a plurality of spring fingers 99, for this purpose.

### REFERENCE NUMERALS

- 1: shielding housing
- 3: printed circuit board (PCB)
- 5: receptacle
- 7: straight passage
- 9: opening
- 11: end
- 13: wall
- 15: sidewall
- 17: top wall
- 19: bottom wall
- 21: front end
- 23: back end
- 25: electrical connector
- 27: electrical connector assembly
- 29: mating connector
- 31: mating axis
- 33: locking mechanism
- 35: U-shaped projection
- 37: slit perpendicular to the mating axis
- 39: slit parallel to the mating axis
- 41: pair of holes
- 43: knob
- 45: backshell
- 47: chamfered edge
- 49: flap
- 51: groove
- 53: pull tab
- 55: pivotable hinge
- 57: cooling hole
- 59: folded sheet
- 61: circumferential direction
- 63: latch with a latching groove
- 65: latching groove
- 67: surface with a latching cam
- 69: latching cam
- 71: attachment means
- 73: pin
- 75a: part with attachment means
- 75b: part without attachment means
- 81: spring finger
- 83: periphery of the openings
- 85: side of the receptacle
- 86: adapter
- 87: gasket
- 89: shoulder
- 91: protrusion
- 93: cable assembly
- 97: shielded cable
- 99: spring finger of backshell

## Claims

1. A shielding housing (1) comprising a receptacle (5) configured to receive an electrical connector assembly (27) of a high-speed electrical connector (25) and a mating connector (29) connected to the high-speed electrical connector (25), wherein the receptacle (5) is formed as a straight passage (7) with openings (9) at both ends (11), either end (11) being configured for receiving one of the connectors of the electrical connector assembly (27) along a mating axis (31), which is coaxial with the straight passage (7) of the receptacle (5).

2. A shielding housing (1) according to claim 1, wherein the shielding housing (1) is formed from a single folded sheet (59) that is electrically conductive.

3. A shielding housing (1) according to claim 2, wherein the sheet (59) is folded around the receptacle (5) of the shielding housing (1); and wherein opposite ends (11) with respect to a circumferential direction (61), the circumferential direction (61) extending around the receptacle (5), are latched together.

4. A shielding housing (1) according to claim 1, wherein the shielding housing (1) is formed from at least two parts (75a, 75b), each part being formed by an electrically conductive sheet material.

5. A shielding housing (1) according to any one of claims 1 to 4, wherein the shielding housing (1) comprises a plurality of attachment means (71); the attachment means (71) being configured to be inserted into a circuit board.

6. A shielding housing (1) according to any one of claims 1 to 4, wherein the shielding housing (1) comprises an adapter (86) with attachment means (71); the adapter (86) being configured to be attached to a circuit board via the attachment means (71); and the shielding housing (1) being configured to engage the adapter (86) in a form-fit.

7. A shielding housing (1) according to any one of claims 1 to 6, wherein the shielding housing (1) comprises at least one spring finger (81) at at least one of the openings (9); the spring finger (81) being elastic and bent in a direction perpendicular to the mating axis (31);

8. A shielding housing (1) according to claim 7, wherein a plurality of spring fingers (81) is arranged around the periphery (83) of at least one of the openings (9).

9. A shielding housing (1) according to claims 7 or 8, wherein at least one spring finger (81) is bent backwards into one of the openings (9) and towards the respective opposite opening (9).

10. A shielding housing (1) according to any one of claims 7 to 9, wherein at least one spring finger (81) protrudes away from the receptacle (5) along the mating axis (31).

11. A shielding housing (1) according to any one of claims 7 to 10, wherein the attachment means and at least one spring finger (81) are stamped out of the same sheet material; and the at least one spring finger (81) is folded and/or bent backwards into one of the openings (9) and towards the respective opposite opening (9).

12. A shielding housing (1) according to any one of claims 1 to 11, wherein one opening (9) has a cross-sectional area perpendicular to the mating axis (31) that is smaller than the cross sectional area perpendicular to the mating axis (31) of the other opening (9); and wherein the difference in the cross-sectional area is covered by the shielding housing (1).

13. A cable assembly (93) comprising a shielding housing (1), wherein the shielding housing (1) is a shielding housing (1) according to any one of claims 1 to 12.

14. A cable assembly (93) according to claim 13, wherein the electrical connector (25) and the mating connector (29) are at least partly received in the shielding housing (1), which seamlessly shields at least parts of the electrical connector (25) and the mating connector (29) from electromagnetic interference (EMI) when the electrical connector (25) and the mating connector (29) are mated within the shielding housing (1).

15. A cable assembly (93) for high-speed data transmission comprising a first shielded cable (97) with an electrical connector (25), a second shielded cable (97) with a mating connector (29) and a shielding housing (1) according to any one of claims 1 to 12, wherein the cable assembly (93) is seamlessly shielded from electromagnetic interference (EMI) along its entire combined length.
